Europäisches Patentamt

European Patent Office

Office européen des brevets

(19)

(11) **EP 1 099 313 B1**

(12)    **EUROPÄISCHE PATENTSCHRIFT**

(45) Veröffentlichungstag und Bekanntmachung des Hinweises auf die Patenterteilung:
**07.04.2004  Patentblatt 2004/15**

(21) Anmeldenummer: **99965391.8**

(22) Anmeldetag: **01.12.1999**

(51) Int Cl.$^7$: **H03M 13/23**, H03M 13/45

(86) Internationale Anmeldenummer:
**PCT/DE1999/003824**

(87) Internationale Veröffentlichungsnummer:
**WO 2000/033467 (08.06.2000 Gazette 2000/23)**

(54) **SOFT-DECISION-DECODIERUNG EINES TERMINIERTEN FALTUNGSCODE**

SOFT DECISION DECODING OF A SCHEDULED CONVOLUTIONAL CODE

DECODAGE A DECISION SOUPLE D'UN CODE DE CONVOLUTION PREDETERMINE

(84) Benannte Vertragsstaaten:
**DE FR GB**

(30) Priorität: **01.12.1998  DE 19855453**

(43) Veröffentlichungstag der Anmeldung:
**16.05.2001  Patentblatt 2001/20**

(73) Patentinhaber: **SIEMENS AKTIENGESELLSCHAFT**
**80333 München (DE)**

(72) Erfinder: **STURM, Thomas**
**D-81673 München (DE)**

(56) Entgegenhaltungen:
**EP-A- 0 391 354**

- **JOERESSEN O J ET AL: "HIGH-SPEED VLSI ARCHITECTURES FOR SOFT-OUTPUT VITERBI DECODING" JOURNAL OF VLSI SIGNAL PROCESSING,NL,KLUWER ACADEMIC PUBLISHERS, DORDRECHT, Bd. 8, Nr. 2, 1. Oktober 1994 (1994-10-01), Seiten 169-181, XP000483302 ISSN: 0922-5773**

**Beschreibung**

Die Erfindung betrifft ein Verfahren und eine Anordnung zur Decodierung eines vorgegebenen Codeworts.

Bei der Decodierung eines Codeworts, das eine vorgegebene Anzahl Stellen aufweist, sollen die informationstragenden Stellen möglichst vollständig wiederhergestellt werden.

Die Decodierung findet auf der Seite des Empfängers statt, der das Codewort über einen gestörten Kanal empfangen hat. Signale werden insbesondere als Boolesche Werte, bevorzugt unterteilt in +1 und -1, über den Kanal übertragen, erfahren dort eine Störung und werden von einem Demodulator in analoge Werte umgesetzt, die mehr oder weniger stark von den vorgegebenen Booleschen Werten ($\pm 1$) abweichen können.

Allgemein wird ausgegangen von K Stellen binärer Information ("Informationsbits") ohne Redundanz $u \in \{\pm 1\}^K$, die von einem Kanalcodierer mittels systematischen Blockcodes oder unsystematischen Blockcodes in ein Codewort $c \in \{\pm 1\}^N$ abgebildet wird. Dabei enthält das Codewort $N - K$ Bits (auch: "Prüfbits"), die als redundante Information zu den N Informationsbits zur Wiederherstellung der Information nach Übertragung über den gestörten Kanal einsetzbar sind.

Der systematische Blockcode fügt zu den $N$ Informationsbits $N - K$ Prüfbits hinzu, die aus den Informationsbits errechnet werden, wobei die Informationsbits selbst unverändert bleiben, wohingegen beim unsystematischen Blockcode die Informationsbits selbst verändert werden, bspw. steckt die Information in einer von einer zur nächsten Stelle durchgeführten Operation. Auch hier sind Prüfbits zur Rekonstruktion der in den Operationen versteckten Information vorgesehen. Nachfolgend wird insbesondere eine technisch bedeutende Variante unsystematischer Blockcodes, die sogenannten terminierten Faltungscodes, betrachtet.

Nun ist es entscheidend von Nachteil, eine Zuordnung des empfangenen Codeworts (mit den mit analogen Werten belegten Stellen) "hart" zu decodieren, d.h. jede Stelle dem jeweils naheliegendsten Booleschen Wert zuzuordnen, da hierbei wertvolle Information verloren geht.

Die **Aufgabe** der Erfindung besteht darin, eine Decodierung eines vorgegebenen Codeworts zu bestimmen, wobei die Decodierung analoge Werte (sog. "Soft-Outputs") liefert, die insbesondere in nachfolgenden Decodierverfahren berücksichtigt werden können und somit eine hohe Fehlerkorrektur bei der Übertragung von Codewörtern über einen gestörten Kanal ermöglichen.

Diese Aufgabe wird gemäß den Merkmalen der unabhängigen Patentansprüche gelöst. Weiterbildungen der Erfindung ergeben sich auch aus den abhängigen Ansprüchen.

Zur Lösung der Aufgabe wird ein Verfahren zur Decodierung eines vorgegebenen Codeworts angegeben,

(a) bei dem das Codewort mehrere Stellen mit unterschiedlichen Werten umfasst;

(b) bei dem jede Stelle des Codeworts einem Soft-Output-Wert zugeordnet wird, wobei die Berechnungsvorschrift für den Soft-Output-Wert für jede Stelle des Codeworts bestimmt ist durch

$$L\big(U_i\big|y\big) = \ln\left(\frac{\sum\limits_{c\in\Gamma^i(+1)} \exp\left(-\frac{(y-c)^T(y-c)}{2\sigma^2}\right)}{\sum\limits_{c\in\Gamma^i(-1)} \pm\exp\left(-\frac{(y-c)^T(y-c)}{2\sigma^2}\right)}\right), \text{ für } i = 1\ldots,K,$$

wobei

$L(U_i|y)$     ein Sicherheitsmaß (Soft-Output) für die i-te Stelle des zu bestimmenden Codeworts;
y     ein zu decodierendes Demodulationsergebnis;
c     ein Codewort;
$\Gamma^i(\pm 1)$     sämtliche Codewörter für $u_i = \pm 1$;
$\sigma^2$     eine Varianz (Kanalstörung)

bezeichnen;

(c) bei dem durch die Zuordnung der einzelnen Stellen des Codeworts zu Soft-Output-Werten die Decodierung desselben bestimmt wird, indem eine Eigenschaft eines Faltungscodes ausgenutzt wird, aus der hervorgeht, dass entsprechend einer Schieberegisteroperation Zustände bestimmt werden, aus denen eine Trellis-Darstellung hervorgeht, wobei bei den Schieberegisteroperationen taktweise Eingabeblöcke von Nachrichtenbits in das Schieberegister geschrieben werden;

(d) bei dem für eine beliebige Wahl von y ∈ R$^N$ Gewichte $\mu_g(s)$ für die Knoten (s, q) der Trellis-Darstellung berechnet werden durch Auswertung von

$$\mu_q : S \to \mathbf{R},$$
$$s \to \exp\left(-\frac{1}{2\sigma^2}\sum_{j=1}^{n}\left(y_{n(q-1)+j} - C_j(s)\right)^2\right)$$

mit

$$C_j(s) = \bigoplus_{i \in Mj} s^i$$

$1 \le j \le n$, $n \in N$, wobei $M_1, ...M_n \subseteq \{1, .., L\}$ charakterisierende Teilmengen sind, über die der Faltungscode definiert wird, wobei S = $\{\pm 1\}^L$ , s ∈ S, s$^i$ die i-te Komponente von s ist, wobei q ∈ {1,...,Q}, Q = a + k - 1, a ∈ **N**, k ∈ **N**, k ≥ 2, L = k · b, b ∈ N, wobei a die Anzahl der Eingabeblöcke ist, k die Blocklänge des Schieberegisters ist, S die Menge der Schieberegisterzeichen ist, L die Bitlänge des Schieberegisters ist;

(e) bei dem Abbildungen A$_m$ anhand der Trellis-Darstellung bestimmt werden, wobei die Trellis-Darstellung in der natürlichen Richtung durchlaufen wird, wobei der Term A$_m$ bestimmt ist durch

$$A_m(s) = \mu_m(s) \sum_{t \in W(s,V_m)} A_{m-1}(t),$$

für m ∈ N
wobei V = $\{\pm 1\}^b$ die Menge an Zustandsübergangszeidhen ist und $V_j \subseteq V$, $j \in N$ das zustandsübergangszeichen nach j Shifts des Schieberegisters ist,
wobei

$$W(t,\hat{V}) = \left\{s \in S; \exists \hat{v} \in \hat{V} \ni T(s,\hat{v}) = t\right\}$$
$$= \begin{cases} \left\{\hat{T}(v,t); v \in V\right\}, & \text{falls } \tau(s) \in \hat{V} \\ 0 & \text{sonst} \end{cases}$$

wobei $\hat{V} \subseteq V$ ;

$$\tau : S \to V$$

wobei

$$s = (s^1;..., s^L)^T \to (s^{L-b+1},..., s^L)^T$$

$$\overset{\wedge}{T} : V \times S \to V$$

wobei

$$s = (v,s) \to (v^1,..., v^b ,s^1,..., s^{L-b})^T$$

$$T : S \times V \to S,$$

wobei

$$(s,v) \to (s^{b+1},..., s^L ,v^1,..., v^b)^T$$

und einem Startwert

$$A_0(s) = \left\{ \begin{array}{l} 1: f\ddot{u}r \ \ s = s_0 \\ 0: \ sonst; \end{array} \right.$$

(f) bei dem Abbildungen $B_m$ anhand der Trellis-Darstellung bestimmt werden, wobei die Trellis-Darstellung entgegen der vorgegebenen Richtung durchlaufen wird, wobei der Term $B_m$ bestimmt ist durch

$$B_m(s) = \mu_{Q-m+1}(s) \sum_{t \in T(s,V_{Q-m+2})} B_{m-1}(t),$$

für $1 \le m \le Q$,
wobei zur Terminierung der Rekursion

$$B_0(s) = \left\{ \begin{array}{l} 1: f\ddot{u}r \ \ s = s_0 \\ 0: sonst; \end{array} \right.$$

bestimmt wird;

(g) bei dem Terme $A_\alpha^i$ ermittelt werden, indem die Trellis-Darstellung erneut durchlaufen wird, wobei die bereits ermittelten Terme $A_m$ und $B_m$ berücksichtigt werden gemäß der Beziehung

$$A_\alpha^i(y) = \sum_{s \in S} A_{j-1}(s) \sum_{t \in T(s,y_j^i(\alpha))} B_{Q-j+1}(t)$$

wobei

$$j = \left[\frac{i-1}{b}\right] + 1;$$

$$V_j^i(\alpha) = \left\{v \in V; v_{\hat{i}} = \alpha\right\}, \ \alpha \in \{\pm 1\};$$

wobei

$i \in \{1,...,K\}$, *wobei* $K = a \cdot b$, $j \in \{1,....,a\}$ *und* $\hat{i} \in \{1,...,n\}$ *mit* $i = (j-1) \cdot n + \hat{i}$

(h) bei dem die K Stellen des Codewortes bestimmt werden gemäß

$$L(U_i|\ y) = \ln\left(\frac{A_{+1}^i(y)}{A_{-1}^i(y)}\right),$$

$i = 1, ..., K.$

Eine Ausgestaltung der Erfindung betrifft den Einsatz des Verfahrens in einem Mobilfunknetz, insbesondere dem GSM-Netz.

Auch ist es eine Weiterbildung, dass nach der Ermittlung der Soft-Outputs eine harte Zuordnung der analogen Werte zu den Booleschen Werten ±1 erfolgt. Dabei wird jeweils der nächstliegende Boolesche Wert für die Zuordnung des analogen Werts ermittelt.

Die ermittelten Soft-Output-Werte können als Eingabewerte. einer weiteren Decodierung bei Verwendung verketteter Codes dienen.

Zur Lösung der Aufgabe wird ferner eine Anordnung zur Decodierung eines vorgegebenen Codeworts angegeben, bei der eine Prozessoreinheit vorgesehen ist, die derart eingerichtet ist, dass eine Prozessoreinheit vorgesehen ist, die derart eingerichtet ist, dass das erfindungsgemäße Verfahren durchführbar ist.

Ausführungsbeispiele der Erfindung werden nachfolgend anhand der Zeichnung dargestellt und erläutert.

Es zeigen

**Fig.1**  eine Darstellung zur digitalen Nachrichtenübertragung:

**Fig.2**  einen Algorithmus in Pseudocode-Notation zum Fortschreiten im Trellis-Diagramm unter Betrachtung aller Zustände zur Berechnung von Knotengewichten;

**Fig.3**  einen Algorithmus in Pseudeocode-Noation zur Ermittlung von Soft-Outputs (allgemeiner Fall);

**Fig.4**  einen Algorithmus in Pseudeocode-Noation zur Ermittlung von Soft-Outputs (Spezialfall: binärer Zustandsübergang);

**Fig.5**  eine Prozessoreinheit.

Nachfolgend werden zunächst der Faltungscode, dann die Komplexitätsreduktion bei der Berechnung von Soft-Outputs und schließlich eine algorithmische Umsetzung der Komplexitätsreduktion näher beschrieben.

**Terminierter Faltungscode**

In der Nachrichtentechnik werden terminierte Faltungscodes meist in Verkettung mit weiteren systematischen oder unsystematischen Blockcodes eingesetzt. Insbesondere dient dabei das Decodierungsergebnis eines Faltungsdecoders als Eingabe für einen weiteren Decoder.

Um eine möglichst niedrige Fehlerrate zu gewährleisten, ist es nötig, "weiche" statt "harte" Decodierungsentscheidungen bei der Faltungsdecodierung für den weiteren Decoder zu liefern, d.h. ein Tupel von "weichen" Werten (Soft-Outputs) aus $\mathbb{R}$ zu erzeugen anstatt ein Tupel von "harten" Booleschen ($\pm 1$) Werten. Der Betrag der jeweiligen "weichen" Entscheidung gibt dann ein Sicherheitsmaß für die Richtigkeit der Entscheidung an.

Abhängig vom Kanalmodell ist eine Berechnung dieser Soft-Outputs nach Gleichung (1) prinzipiell möglich. Allerdings beträgt dabei die numerische Komplexität zur Berechnung eines Soft-Outputs $O(2^K)$, wobei $K$ die Zahl der Nachrichtenbits angibt. Bei realistisch großen $K$ sind diese Formeln also nicht auswertbar, insbesondere, da alle paar Millisekunden erneut ein solches Codewort zu berechnen ist (Echtzeitanforderung).

Eine Konsequenz lag in dem Verzicht auf Soft-Outputs (mit allen Konsequenzen für die Wort- und Bitfehlerraten) bzw. es wurden weniger aufwendige Approximationen zur Bestimmung der Soft-Outputs durchgeführt.

Im folgenden wird eine Möglichkeit für terminierte Faltungscodes angegeben, mit deren Hilfe in einer Trellis-Darstellung diese Komplexität auf $O(K)$ zur Berechnung aller Soft-Outputs reduziert werden kann, d.h. eine exakte Auswertung der Gleichung (1) wird damit möglich.

Nachfolgend werden die Bits des Codes in $\{\pm 1\}$-Repräsentation dargestellt. Im Vergleich zu einer informationstechnisch oft üblichen $\{0, 1\}$-Repräsentation korrespondiert -1 mit 1 und 1 mit 0.

Auf einem Körper $\{\pm 1\}$ sind Addition $\oplus$ und Multiplikation $\odot$ wie folgt definiert:

| $-1 \oplus -1 = 1$ | $-1 \odot -1 = -1$ |
|---|---|
| $-1 \oplus 1 = -1$ | $-1 \odot 1 = 1$ |
| $1 \oplus -1 = -1$ | $1 \odot -1 = 1$ |
| $1 \oplus 1 = 1$ | $1 \odot 1 = 1$ |

Die Codierung erfolgt mit Hilfe eines "Schieberegisters", in welches taktweise Bitblöcke (Eingabeblöcke) der Nachrichtenbits (Informationsbits) geschrieben werden. Die Kombination der Bits des Schieberegisters erzeugt dann einen Bitblock des Codeworts. Das Schieberegisters ist je mit +1 Bits vorbelegt. Zum Abschluß der Codierung (Terminierung) werden Blöcke von Tail-Nullen (+1) nachgeschoben. Wie eingangs erwähnt wurde, werden mittels Codierung den Informationsbits Prüfbits zugeordnet, anhand derer Bitfehler korrigiert werden können.

Für die weiteren Ausführungen werden definiert:

| | |
|---|---|
| $b \in \mathbb{N}$ | Anzahl der Eingabebits pro Block |
| $V := \{\pm 1\}^b$ | Menge der Zustandsübergangszeichen |
| $a \in \mathbb{N}$ | Anzahl der Eingabeblöcke |
| $K := a \cdot b$ | Anzahl der Nachrichtenbits ohne Tail-Nullen |
| $k \in \mathbb{N}, k \geq 2$ | Blocklänge des Schieberegisters, Eindringtiefe |
| $L := k \cdot b$ | Bitlänge des Schieberegisters |
| $S := \{\pm 1\}^L$ | Menge der Schieberegisterzeichen |
| $n \in \mathbb{N}$ | Anzahl der Ausgabebits pro Block |
| $Q := a + k - 1$ | Anzahl der Zustandsübergänge, Eingabeblöcke + Nullen |
| $N := n \cdot Q$ | Anzahl der Codebits |
| $R := \frac{b}{n}$ | Coderate |

Hierbei sei angemerkt, daß die Coderate nicht $K/N$ beträgt, da die Nachrichtenbits ohne die Nullen (+1) der Faltungsterminierung gezählt wurden.

Weiterhin seien $s_0 \in S$ und $\upsilon_0 \in V$ die jeweiligen Nullelemente, d.h.

$$s_0 = (+1, \ldots , +1)^\mathsf{T}, \quad \upsilon_0 = (+1, \ldots , +1)^\mathsf{T}. \tag{9}$$

Die Zustandsübergangsfunktion des Schieberegisters sei

$$T : S \times V \rightarrow S, \tag{10}$$

$$(s, \upsilon) \mapsto (s^{b+1}, \dots , s^{L}, \upsilon^{1}, \dots , \upsilon^{b})^{\mathsf{T}}. \tag{11}$$

Der terminierte Faltungscode wird über die charakterisierenden Teilmengen

$$M_1, \dots , M_n \subseteq \{1, \dots , L\}, \tag{12}$$

definiert (Kombination der Registerbits, alternativ in Polynomdarstellung). Die Codierung des aktuellen Registerinhaltes erfolgt über

$$C : S \rightarrow \{\pm 1\}^n, \tag{13}$$

$$s \mapsto C(s) \quad \text{mit } C_j(s) := \bigoplus_{i \in M_j} s^i, \quad \text{für } 1 \leq j \leq n. \tag{14}$$

Dabei steht $s^i$ für die $i$-te Komponente von $s$.
Die Codierung eines Nachrichtenwortes ist schließlich definiert mittels

$$\varphi : \{\pm 1\}^K \rightarrow \{\pm 1\}^N, \tag{15}$$

$$u \mapsto \begin{pmatrix} C(s_1) \\ \vdots \\ (s_Q) \end{pmatrix}, \tag{16}$$

wobei $s_0 \in S$ der Nullzustand (Nullelement) ist,

$$u = \begin{pmatrix} \nu_1 \\ \vdots \\ \nu_a \end{pmatrix}, \quad \nu_i \in V, \quad 1 \leq i \leq a, \tag{17}$$

$$\upsilon_i := \upsilon_0, \ a + 1 \leq i \leq Q, \tag{18}$$

und weiter

$$s_i := T(s_{i-1}, v_i), \ 1 \leq i \leq Q. \tag{19}$$

Nach Definition von $T$ ergibt sich

$$s_{Q+1} := T(s_Q, \upsilon_0) = s_0. \tag{20}$$

Die Menge aller Codeworte ist demnach

$$\varphi\left(\{\pm1\}^K\right) := \{\varphi(u) \in \{\pm1\}^N; \, u \in \{\pm1\}^K\}. \tag{21}$$

Oft werden anstatt der Mengen $M_j$ Polynome

$$p_j \in \{0,1\}[D] \text{ mit } \deg(p_j) \leq L - 1$$

zur Codedefinition verwendet, d.h.

$$p_j(D) = \sum_{i=0}^{L-1} \gamma_{i,j} D^i, \tag{22}$$

mit $\gamma_{i,j} \in \{0, 1\}$ $i = 0, ..., L - 1,$
$\qquad j = 1, ..., n.$

Es gelten dann für $j = 1, ..., n$ die Umformungen:

$$M_j = \{i \in \{1,..., L\}; \, \gamma_{L-i,j} = 1\} \tag{23}$$

$$p_j(D) = \sum_{i \in M_j} D^{L-i}. \tag{24}$$

**Blockcode-Darstellung**

Da ein terminierter Faltungscode ein Blockcode ist, lassen sich die Codebits $c_j$, $1 \leq j \leq N$, aus den Nachrichtenbits $u_i$, $1 \leq i \leq K$, mit Indexmengen $J_j$ auch wie folgt darstellen:

$$c_j := \bigoplus_{i \in J_j} u_i, \quad \text{für } 1 \leq j \leq N, \tag{25}$$

wobei

$$J_1, ... , J_N \subseteq \{1, ... , K\}. \tag{26}$$

gilt. Die Indexmengen $J_j$ lassen sich direkt aus den obigen Indexmengen $M_m$ der Codedefinition berechnen.
Betrachte

$$j = n(q - 1) + m, \, q = 1,...,Q, \, m = 1,..., n. \tag{27}$$

$$c_j = C_m(s_q) = \bigoplus_{i \in M_m} (s_q)^i = \bigoplus_{i \in M_m} u_{i+b(q-k)}, \tag{28}$$

wobei $u_i := +1$ für $i \notin \{1, \dots, K\}$ gilt.

Ferner gilt

$$c_j = \bigoplus_{i-b(q-k)\in M_m} u_i = \bigoplus_{i \in M_m + b(q-k)} u_i, \qquad (29)$$

und somit folgt für $j = 1, \dots, N$

$$J_j = \{1, \dots, K\} \cap (M_m + b(q - k))$$

$$= \{i \in \{1, \dots, K\}; i - b(q - k) \in M_m\}. \qquad (30)$$

**Beispiel: SACCH-Faltungscode**

Der in der GSM Technical Specification GSM 05.03, Version 5.2.0 (Channel coding), im Abschnitt 4.1.3 beschriebene Faltungscode lautet in obiger Terminologie:

| | |
|---|---|
| $b = 1$ | Anzahl der Eingabebits pro Block |
| $V = \{\pm 1\}$ | Menge der Zustandsübergangszeichen |
| $a = 224$ | Anzahl der Eingabeblöcke |
| $K = 224$ | Anzahl der Nachrichtenbits ohne Tail-Nullen |
| $k = 5$ | Blocklänge des Schieberegisters, Eindringtiefe |
| $L = 5$ | Bitlänge des Schieberegisters |
| $S = \{\pm 1\}^5$ | Menge der Schieberegisterzeichen |
| $n = 2$ | Anzahl der Ausgabebits pro Block |
| $Q = 228$ | Anzahl der Zustandsübergänge, Eingabeblöcke + Nullen |
| $N = 456$ | Anzahl der Codebits |
| $R = \dfrac{1}{2}$ | Coderate |
| $M_1 = \{1, 2, 5\}$ | charakterisierende Menge; Polynom: $1 + D^3 + D^4$ |
| $M_2 = \{1, 2, 4, 5\}$ | charakterisierende Menge; Polynom: $1 + D + D^3 + D^4$ |

**Soft-Outputs bei einem AWGN-Kanalmodell**

Nachfolgend werden insbesondere der Übersicht halber Berechnungsvorschriften zur Ermittlung der Soft-Outputs hergeleitet.

Dazu werden ein Wahrscheinlichkeitsraum $(\Omega, S, P)$ und eine $K$-dimensionale Zufallsvariable $U : \Omega \to \{\pm 1\}^K$ mit den Eigenschaften

- Die Komponenten $U_1, \dots, U_K : \Omega \to \{\pm 1\}$ sind stochastisch unabhängig.

- Für $i = 1, \dots, K$ gilt

$$P(\{\omega \in \Omega; U_i(\omega) = -1\}) = P(\{\omega \in \Omega; U_i(\omega) = +1\}). \qquad (31)$$

betrachtet.

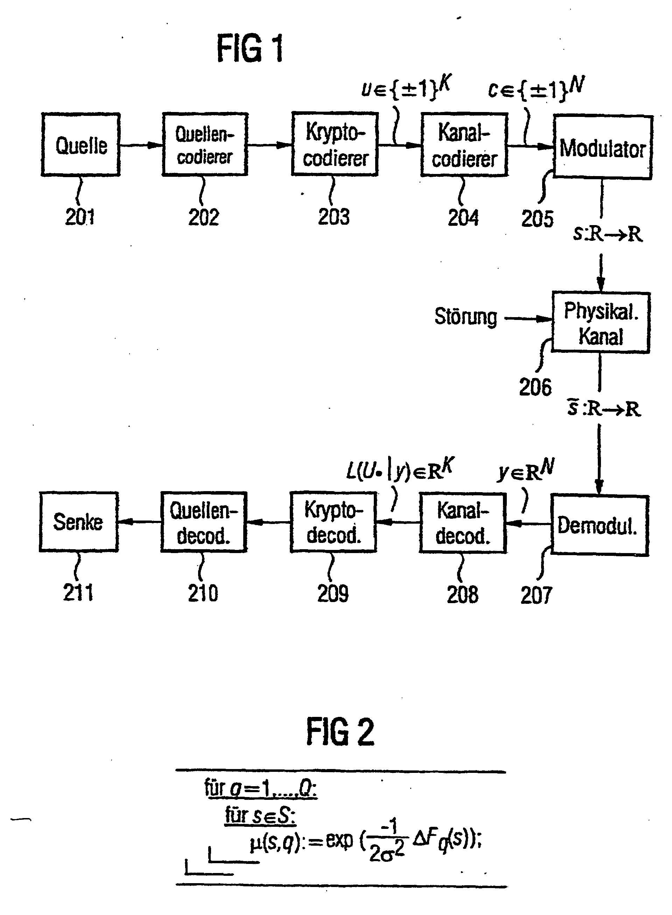

**Fig. 1** zeigt eine Darstellung zur digitalen Nachrichtenübertragung. Eine Einheit aus Quelle 201, Quellencodierer 202 und Kryptocodierer 203 bestimmt eine Information $u \in \{\pm 1\}^K$, die als Eingabe für einen (ggf. auch mehrere) Kanalcodierer 204 dient. Der Kanalcodierer 204 erzeugt ein Codewort $c \in \{\pm 1\}^N$, das in einen Modulator 205 eingespeist und über einen gestörten physikalischen Kanal 206 zu einem Empfänger übertragen wird, wo es in einem Demodulator 207 zu einem reellwertigen Codewort $y \in \mathbb{R}^N$ bestimmt wird. Dieses Codewort wird in einem Kanaldecodierer 208 in eine reellwertiges Information umgesetzt. Gegebenenfalls kann in einem weiteren Decodierer auch eine "harte" Zuordnung zu den Booleschen Werten $\pm 1$ getroffen werden, so daß die empfangene Information in Boolescher Notation vorliegt. Eine Einheit aus Kryptodecoder 209, Quellendecoder 210 und Senke 211 komplettiert den Empfänger. Die beiden Einheiten Kryptocodierer 203 und Kryptodecoder 209 sind dabei optional.

Die zu rekonstruierende Information $u \in \{\pm1\}^K$ des Kryptocodierers 203 wird als Realisierung der *Zufallsvariablen U* interpretiert, da beim Empfänger nichts über die Wahl von u̲ bekannt ist.

Die Ausgabe $c \in \{\pm1\}^N$ des Kanalcodierers 204 ist also eine Realisierung der Zufallsvariablen $\varphi(U)$.

Die Ausgabe $y \in R^N$ des Demodulators 207 wird als Realisierung der Zufallsvariablen

$$Y : \Omega \to \mathbb{R}^N, \tag{32}$$

$$\omega \mapsto \varphi(U(\omega)) + Z(\omega), \tag{33}$$

interpretiert, wobei eine Zufallsvariable $Z : \Omega \to \mathbb{R}^N$ die Kanalstörung auf dem physikalischen Kanal 206 repräsentiert.

Im folgenden wird ein AWGN-Kanalmodell angenommen, d.h. $Z$ ist eine $N(0, \sigma^2 I_N)$ normalverteilte Zufallsvariable, die stochastisch unabhängig von $U$ bzw. $\varphi(U)$ ist. Die Varianz $\sigma^2$ berechnet sich aus dem Verhältnis von Rauschleistungsdichte und mittlerer Energie auf dem Kanal 206 und wird hier als bekannt vorausgesetzt.

Basierend auf einer Realisierung $y$ von $Y$ soll die unbekannte Ausgabe $u \in \{\pm1\}^K$ des Kryptocodierers rekonstruiert werden. Um die unbekannten Größen $u_1, \ldots, u_K$ zu schätzen, wird die Verteilung der Zufallsvariablen $U$ unter der Bedingung, daß $y$ empfangen wurde, untersucht.

Die Tatsache, daß die Zufallsvariable $Y$ eine stetige Zufallsgröße ist, hat zur Folge, daß die Betrachtung von $U$ unter der Bedingung, daß $y$ empfangen wurde ($Y(\hat{\omega}) = y$), äußerst kompliziert ist.

Zunächst wird für $i \in \{1, \ldots, K\}$ und $\alpha \in \{\pm1\}$ definiert

$$\Gamma^i(\alpha) := \{\varphi(u); u \in \{\pm1\}^K; u_i = \alpha\}. \tag{34}$$

In einem vorbereitenden Schritt werden für $\varepsilon > 0$ und unter Beachtung der Injektivität der Codierungsabbildung $\varphi$ die folgenden Größen betrachtet:

$$
\begin{aligned}
L_\epsilon(U_i|y) &:= \ln\left( \frac{P(\{\omega \in \Omega;\ U_i(\omega) = +1\} \mid \{\omega \in \Omega;\ Y(\omega) \in M_{y,\epsilon}\})}{P(\{\omega \in \Omega;\ U_i(\omega) = -1\} \mid \{\omega \in \Omega;\ Y(\omega) \in M_{y,\epsilon}\})} \right) \\
&= \ln\left( \frac{\sum\limits_{c \in \Gamma^i(+1)} P(\{\omega \in \Omega;\ \varphi(U(\omega)) = c\} \mid \{\omega \in \Omega;\ Y(\omega) \in M_{y,\epsilon}\})}{\sum\limits_{c \in \Gamma^i(-1)} P(\{\omega \in \Omega;\ \varphi(U(\omega)) = c\} \mid \{\omega \in \Omega;\ Y(\omega) \in M_{y,\epsilon}\})} \right),
\end{aligned}
\tag{35}
$$

für $i = 1, \ldots, K$, wobei $M_{y,t} := [y_1, y_1 + \varepsilon] \times \ldots \times [y_N, y_N + \varepsilon]$ gilt.

Durch Anwendung des Satzes von Bayes ergibt sich:

$$
\begin{aligned}
L_\epsilon(U_i|y) &= \ln\left( \frac{\sum\limits_{c \in \Gamma^i(+1)} P(\{\omega \in \Omega;\ Y(\omega) \in M_{y,\epsilon}\} \mid \{\omega \in \Omega;\ \varphi(U(\omega)) = c\})}{\sum\limits_{c \in \Gamma^i(-1)} P(\{\omega \in \Omega;\ Y(\omega) \in M_{y,\epsilon}\} \mid \{\omega \in \Omega;\ \varphi(U(\omega)) = c\})} \right) \\
&= \ln\left( \frac{\sum\limits_{c \in \Gamma^i(+1)} \int\limits_{M_{y,\epsilon}} \exp\left( -\frac{(x-c)^\mathsf{T}(x-c)}{2\sigma^2} \right) dx}{\sum\limits_{c \in \Gamma^i(-1)} \int\limits_{M_{y,\epsilon}} \exp\left( -\frac{(x-c)^\mathsf{T}(x-c)}{2\sigma^2} \right) dx} \right).
\end{aligned}
\tag{36}
$$

Wird nun durch mehrfache Verwendung der Regel von L'Hospital der Grenzübergang von $L_\varepsilon(U_i|y)$ für $\varepsilon \downarrow 0$ betrachtet, so erhält man für jedes Zeichen den Soft-Output $L(U_i|y)$ wie in Gleichung (1).

Da

$$\Gamma^i(+1) \cup \Gamma^i(-1) = \{\pm 1\}^K$$

gilt, sind zur Auswertung von Gleichung (1) insgesamt $O(2^K)$ numerische Operationen notwendig.

Der Vektor $L(U_\bullet|y) \in \mathbb{R}^K$ ist das Ergebnis des Decodierers 208.

**Komplexitätsreduktion bei der Bestimmung der Soft-Outputs**

**Soft-Output-Bestimmung für Faltungscodes**

Zunächst werden die speziellen Eigenschaften der terminierten Faltungscodierung zu einer aufgegliederten Darstellung der Soft-Output-Formel (1) eingesetzt.

Es wird zu einer beliebigen aber fest gewählten Ausgabe $y \in \mathbb{R}^N$ des Demodulators 207 die folgende Bewertungsfunktion (eine Viterbi-Metrik) von Codewörtern betrachtet:

$$F : \{\pm 1\}^N \to \mathbb{R}_0^+, \qquad (37)$$

$$c \mapsto \sum_{j=1}^{N} (y_j - c_j)^2. \qquad (38)$$

Für zulässige Codewörter $c \in \{\pm 1\}^N$, d.h., $c \in \varphi(\{\pm 1\}^K)$, läßt sich $F(c)$ mit der Schieberegister-Darstellung wie folgt zerlegen:

$$F(c) = \sum_{q=1}^{Q} \underbrace{\sum_{j=1}^{n} \left( y_{n(q-1)+j} - C_j(\tilde{s}_q^c) \right)^2}_{=:\Delta F_q(\tilde{s}_q^c)}, \qquad (39)$$

wobei $\tilde{s}_q^c$ für den $q$-ten Zustand des Schieberegisters bei der (eindeutigen) Erzeugung des Wortes $c$ steht.

Nun wird für $i = 1, \ldots, K$ und $\alpha \in \{\pm 1\}$ definiert:

$$A_\alpha^i(y) := \sum_{c \in \Gamma^i(\alpha)} \exp\left( -\frac{(y-c)^\top (y-c)}{2\sigma^2} \right) = \sum_{c \in \Gamma^i(\alpha)} \prod_{q=1}^{Q} \exp\left( -\frac{1}{2\sigma^2} \Delta F_q(\tilde{s}_q^c) \right). \qquad (40)$$

Damit gilt also für die Soft-Outputs

$$L(U_i|y) = \ln\left( \frac{A_{+1}^i(y)}{A_{-1}^i(y)} \right), \quad i = 1, \ldots, K. \qquad (41)$$

Nachfolgend werden die Werte $A_\alpha^i(y)$ mit Hilfe einer Trellis-Diagramm-Darstellung (auch: Trellis-Diagramm oder Trellis-Darstellung) bestimmt.

Zur Reduktion der Berechnungskomplexität wird in den folgenden Abschnitten wie folgt vorgegangen:

- Verallgemeinerung von $A_\alpha^i$ durch Abbildungen $\tilde{A}_m$.

- Rekursive Darstellung von $\tilde{A}_m$ durch Abbildungen $A_m$, deren Werte mit einem "Von-Links-nach-Rechts"-Durchlauf eines Trellis-Diagramms berechnet werden.

- Umkehrung der Rekursion durch Abbildungen $B_m$, deren Werte mit einem "Von-Rechts-nach-Links"-Durchlauf eines Trellis-Diagramms berechnet werden.

- Gemeinsame Berechnung aller $A_\alpha^i$ mittels eines weiteren Trellis-Diagramm-Durchlaufs unter Verwendung von $A_m$ und $B_m$.

Als Trellis-Diagramm wird hier eine Menge

$$T = \{(s, q); s \in S, q = 0, \dots, Q + 1\} \tag{42}$$

benannt. Die Elemente $(s, q)$ dieser Menge werden auch als Knoten im Trellis-Diagramm bezeichnet, wobei $s$ einen Zustand darstellt und $q$ als dynamischer Wert (insbesondere die Zeit) angesehen wird.

**Allgemeine rekursive Darstellung**

Zunächst sind einige Definitionen nötig, um die $A_\alpha^i$ in einer verallgemeinerten Form darzustellen, die eine spätere Umformung erlaubt. Deshalb wird bestimmt

$$s_1^u := T(s_0, u_1), u \in V^m = V \times \dots \times V, m \geq 1, \tag{43}$$

$$s_j^u := T(s_{j-1}^u, u_j)\ u \in V^m, m \geq j > 2, \tag{44}$$

d.h., $s_j^u$ repräsentiert den Zustand des Schieberegisters nach $j$ Shifts des Registers mit den Eingabezeichen $u_1, \dots, u_j$.

Weiterhin werden Mengen $V_j \subseteq V, j \in \mathbb{N}$, die die zulässigen Zustandsübergangszeichen im $j$-ten Schritt enthalten, betrachtet. Ferner werden Produktmengen definiert zu

$$U_m := V_1 \times \dots \times V_m \subseteq V^m, \quad m \in \mathbb{N}, \tag{45}$$

d.h., $U_m$ enthält die ersten $m$ Komponenten der zulässigen Eingabeworte.

Für $q \in \mathbb{N}$ werden Abbildungen

$$\mu_q : S \to \mathbb{R} \tag{46}$$

betrachtet, und für $m \in \mathbb{N}$ und Eingabewortmengen $U_m \subseteq V^m$ werden Abbildungen definiert

$$\tilde{A}_m : \wp(S) \to \mathbb{R}, \tag{47}$$

$$E \mapsto \sum_{\substack{(u \in U_m) \\ \wedge (s_m^u \in E)}} \prod_{j=1}^{m} \mu_j(s_j^u), \tag{48}$$

d.h. es wird über alle zulässigen Eingabeworte summiert, deren Schieberegister einen Endzustand in $E$ erreicht. Falls es keine solchen Eingabeworte gibt, so ist die Summe über eine leere Indexmenge zu 0 bestimmt.

Zusätzlich wird eine Abbildung bestimmt zu

$$W : S \times \wp(V) \to \wp(S), \tag{49}$$

$$(t, \hat{V}) \mapsto \left\{ s \in S;\ \exists \hat{v} \in \hat{V} \ni T(s, \hat{v}) = t \right\}, \tag{50}$$

d.h., $W$ bildet $(t, \overset{\wedge}{V})$ in die Menge aller Zustände ab, die den Zustand $t$ mit einem Übergangszeichen aus $\overset{\wedge}{V}$ erreichen können.

Es gilt für $m \geq 2$, $E \subseteq S$

$$\begin{aligned}
\tilde{A}_m(E) &= \sum_{\substack{(u \in U_m) \\ \wedge (s_m^u \in E)}} \prod_{j=1}^{m} \mu_j(s_j^u) \\
&= \sum_{s \in E} \sum_{\substack{(u \in U_m) \\ \wedge (s_m^u = s)}} \prod_{j=1}^{m} \mu_j(s_j^u) \\
&= \sum_{s \in E} \mu_m(s) \sum_{\substack{(u \in U_m) \\ \wedge (s_m^u = s)}} \prod_{j=1}^{m-1} \mu_j(s_j^u) \\
&= \sum_{s \in E} \mu_m(s) \sum_{\substack{(u \in U_{m-1}) \\ \wedge (s_{m-1}^u \in W(s, V_m))}} \prod_{j=1}^{m-1} \mu_j(s_j^u) \\
&= \sum_{s \in E} \mu_m(s) \tilde{A}_{m-1} \left( W(s, V_m) \right). \tag{51}
\end{aligned}$$

Bei der Umformung im vorletzten Schritt ist zu beachten, daß es genau ein Übergangszeichen $v \in V_m$ gibt mit $T(s_{m-1}^u, v) = s$, wenn $s_{m-1}^u$ in $W(s, V_m)$ liegt, d.h., es sind keine Vielfachheiten zu beachten.

Nun betrachte man für $m \geq 2$ Abbildungen

$$A_m : S \to \mathbb{R}, \tag{52}$$

$$s \mapsto \mu_m(s) \tilde{A}_{m-1} \left( W(s, V_m) \right). \tag{53}$$

Somit läßt sich für $m \geq 3$ eine Rekursionsformel ableiten:

$$A_m(s) = \mu_m(s)\tilde{A}_{m-1}\left(W(s, V_m)\right)$$
$$= \mu_m(s) \sum_{t \in W(s,V_m)} \mu_{m-1}(t)\tilde{A}_{m-2}\left(W(t, V_{m-1})\right)$$
$$= \mu_m(s) \sum_{t \in W(s,V_m)} A_{m-1}(t). \tag{54}$$

Weiter gilt:

$$A_2(s) = \mu_2(s)\tilde{A}_1\left(W(s, V_2)\right)$$
$$= \mu_2(s) \sum_{\substack{(u \in U_1) \\ \wedge(s_1^u \in W(s,V_2))}} \mu_1(s_1^u)$$
$$= \mu_2(s) \sum_{t \in W(s,V_2)} \mu_1(t)\delta_{s_0 \in W(t,V_1)}$$
$$= \mu_2(s) \sum_{t \in W(s,V_2)} \mu_1(t) \underbrace{\sum_{\hat{\imath} \in W(t,V_1)} \underbrace{\delta_{\hat{\imath}=s_0}}_{=:A_0(\hat{\imath})}}_{=:A_1(t)} \tag{55}$$

Zusammenfassend gilt also für $s \in S$, $E \subseteq S$:

$$A_0(s) = \begin{cases} 1, & \text{für } s = s_0, \\ 0, & \text{sonst} \end{cases}, \tag{56}$$

$$A_m(s) = \mu_m(s) \sum_{t \in W(s,V_m)} A_{m-1}(t), \quad \text{für } m \in \mathbb{N}, \tag{57}$$

$$\tilde{A}_m(E) = \sum_{s \in E} A_m(s), \quad \text{für } m \in \mathbb{N}. \tag{58}$$

Die Mengen $W(s, V_m)$ können konstruktiv dargestellt werden. Dazu werden zwei weitere Abbildungen betrachtet. Es wird definiert

$$\tau : S \rightarrow V, \tag{59}$$

$$s = (s^1, \dots, s^L)^T \mapsto (s^{L-b+1}, \dots, s^L)^T, \tag{60}$$

d.h., wenn der Zustand $s$ Ergebnis eines Zustandsübergangs ist, so war $\tau(s)$ das zugehörige Zustandsübergangszeichen. Weiter wird definiert

$$\hat{T}: V \times S \to S, \tag{61}$$

$$(\upsilon, s) \mapsto (\upsilon^1, \dots, \upsilon^b, s^1, \dots, s^{L-b})^{\mathsf{T}}, \tag{62}$$

d.h. $\hat{T}$ dreht die Richtung der Schieberegisteroperation um.

Es gilt dann

$$T\left(\hat{T}(v,s), \tau(s)\right) = s, \quad \text{für alle } s \in S,\ v \in V \tag{63}$$

und für alle $t \in S$ und $\hat{V} \subseteq V$ gilt ferner

$$W(t, \hat{V}) = \left\{ s \in S;\ \exists \hat{v} \in \hat{V} \ni T(s, \hat{v}) = t \right\}$$
$$= \begin{cases} \left\{ \hat{T}(v, t);\ v \in V \right\}, & \text{falls } \tau(t) \in \hat{V}, \\ \emptyset, & \text{sonst.} \end{cases} \tag{64}$$

Die Rekursionsformel (57) für $A_m(s)$ läßt sich also wie folgt konstruktiv aufschreiben:

$$A_m(s) = \mu_m(s) \sum_{t \in W(s, V_m)} A_{m-1}(t)$$
$$= \begin{cases} \mu_m(s) \sum_{v \in V} A_{m-1}\left(\hat{T}(v, s)\right), & \text{falls } \tau(s) \in V_m, \\ 0, & \text{sonst.} \end{cases} \tag{65}$$

Es sei vermerkt, daß in diesem Abschnitt keinerlei Einschränkungen an die Menge $V$ der Zustandsübergangszeichen und an die Mengen $V_j \in \wp(V)$ gemacht wurden.

**Rekursionsumkehrung**

Im folgenden wird eine Rekursion in "umgekehrter Richtung" gegenüber der obigen Rekursion beschrieben. Diese neue Rekursion wird mit Hilfe der Rekursionsformel (57) für $A_m(s)$ definiert.

Dazu sei

$$T(t, \hat{V}) := \left\{ T(t, \hat{v});\ \hat{v} \in \hat{V} \right\}, \quad \text{für } t \in S,\ \hat{V} \subseteq V \tag{66}$$

und für $M \in \mathbb{N}$, $0 \le m \le Q$ betrachtet man Abbildungen

$$B_m : S \to \mathbb{R}, \tag{67}$$

mit folgender rekursiver Eigenschaft:

$$
\begin{aligned}
\sum_{s \in S} A_m(s) \sum_{t \in T(s, V_{m+1})} B_{Q-m}(t) &= \\
&= \sum_{s \in S} \mu_m(s) \sum_{\hat{i} \in W(s, V_m)} A_{m-1}(\hat{i}) \sum_{t \in T(s, V_{m+1})} B_{Q-m}(t) \\
&= \sum_{\hat{i} \in S} \sum_{s \in T(\hat{i}, V_m)} \mu_m(s) A_{m-1}(\hat{i}) \sum_{t \in T(s, V_{m+1})} B_{Q-m}(t) \\
&= \sum_{\hat{i} \in S} A_{m-1}(\hat{i}) \underbrace{\sum_{s \in T(\hat{i}, V_m)} \mu_m(s) \sum_{t \in T(s, V_{m+1})} B_{Q-m}(t)}_{=:B_{Q-m+1}(s)},
\end{aligned}
$$

d.h.

$$\sum_{s \in S} A_m(s) \sum_{t \in T(s, V_{m+1})} B_{Q-m}(t) = \sum_{s \in S} A_{m-1}(s) \sum_{t \in T(s, V_m)} B_{Q-m+1}(t). \tag{68}$$

Durch mehrfache Anwendung der Gleichung (68) ergibt sich für ein beliebiges $j \in \{1, \ldots, m+1\}$

$$\sum_{s \in S} A_m(s) \sum_{t \in T(s, V_{m+1})} B_{Q-m}(t) = \sum_{s \in S} A_{j-1}(s) \sum_{t \in T(s, V_j)} B_{Q-j+1}(t). \tag{69}$$

Nach obiger Definition lautet also die Rekursionsformel

$$B_m(s) = \mu_{Q-m+1}(s) \sum_{t \in T(s, V_{Q-m+2})} B_{m-1}(t), \qquad \text{für } 1 \le m \le Q. \tag{70}$$

Zur Terminierung der Rekursion werden definiert

$$B_0(s) = \begin{cases} 1, & \text{für } s = s_0, \\ 0, & \text{sonst} \end{cases}. \tag{71}$$

Mit dieser Terminierung und den Gleichungen (58) sowie (69) läßt sich

$$\tilde{A}_Q(W(s_0, V_{Q+1}))$$

für $V_{Q+1} := \{\upsilon_0\}$ und mit einem beliebigen $j \in \{1, \dots, Q + 1\}$ wie folgt darstellen

$$\begin{aligned}
\tilde{A}_Q(W(s_0, V_{Q+1})) &= \sum_{s \in W(s_0, V_{Q+1})} A_Q(s) \\
&= \sum_{s \in S} A_Q(s) \sum_{t \in T(s, \{v_0\})} B_0(t) \\
&= \sum_{s \in S} A_Q(s) \sum_{t \in T(s, V_{Q+1})} B_0(t) \\
&= \sum_{s \in S} A_{j-1}(s) \sum_{t \in T(s, V_j)} B_{Q-j+1}(t). \quad (72)
\end{aligned}$$

Bemerkung: Bei der Auswertung von (72) geht $V_j$ nicht in die Berechnung der benötigten $A_m$ bzw. $B_m$ ein.

Berechnung von $A_\alpha^i$

Mit den Vorarbeiten aus den vorangegangenen Abschnitten läßt sich $A_\alpha^i$ nun auf einfache Weise berechnen.
Hierzu werden definiert:

$$V_j := V_i \text{ für } j \in \{1, \dots, \alpha\}, \quad (73)$$

$$V_j := \{\upsilon_0\}, \text{ für } j \in \{\alpha + 1, \dots, Q + 1\}, \quad (74)$$

d.h. alle zulässigen Codeworte sind über die Zustände $s_j^u$ mit

$$u \in U_Q = V_1 \times \dots \times V_Q$$

definiert.
Die bei der Berechnung der $A_\alpha^i$ verwendeten Codeworte sind durch $u_i = \alpha$ eingeschränkt. Zu einer beliebigen aber festen Wahl von $i \in \{1, \dots, K\}$ gibt es genau ein $j \in \{1, \dots, a\}$ und genau ein $\hat{\imath} \in \{1, \dots, b\}$ mit

$$i = (j - 1) \cdot b + \hat{\imath}. \quad (75)$$

Ferner werden für eine beliebige aber feste Wahl von $\alpha \in \{\pm 1\}$ definiert:

$$V_j^i(\alpha) := \{\upsilon \in V \, ; \, \upsilon_i = \alpha\} \quad (76)$$

$$U_Q^i(\alpha) := V_1 \times \dots \times V_{j-1} \times V_j^i(\alpha) \times V_{j+1} \times \dots \times V_Q \subset U_Q, \quad (77)$$

d.h., die Codeworte aus $\Gamma^i(\alpha)$ sind über die Zustände $s_j^u$ mit $u \in U_Q^i(\alpha)$ bestimmt.
Zu einer beliebigen aber festen Wahl von $y \in^j \mathbb{R}^N$ definiere für $q \in \{1, \dots, Q\}$

$$\mu_q : S \to \mathbb{R}, \quad (78)$$

$$s \mapsto \exp\left(-\frac{1}{2\sigma^2}\sum_{j=1}^{n}\left(y_{n(q-1)+j} - C_j(s)\right)^2\right) = \exp\left(-\frac{1}{2\sigma^2}\Delta F_q(s)\right). \quad (79)$$

Nach Definition des Faltungscodes gilt für alle $s_Q^u$ mit $u \in U_Q$

$$s_{Q+1}^u = T(s_Q^u, u_{Q+1}) = s_0, \; u_{Q+1} \in V_{Q+1} = \{v_0\}, \quad (80)$$

also

$$s_Q^u \in W(s_0, V_{Q+1}). \quad (81)$$

Damit gilt unter Beachtung von Gleichung (72)

$$A_\alpha^i(y) = \sum_{c \in \Gamma^i(\alpha)} \prod_{q=1}^{Q} \exp\left(-\frac{1}{2\sigma^2}\Delta F_q(\tilde{s}_q^c)\right)$$

$$= \sum_{u \in U_Q^i(\alpha)} \prod_{q=1}^{Q} \mu_q(s_q^u)$$

$$= \sum_{\substack{(u \in U_Q^i(\alpha)) \\ \wedge (s_Q^u \in W(s_0, V_{Q+1}))}} \prod_{q=1}^{Q} \mu_q(s_q^u)$$

$$= \tilde{A}_Q(W(s_0, V_{Q+1}))$$

$$= \sum_{s \in S} A_{j-1}(s) \sum_{t \in T(s, V_j^i(\alpha))} B_{Q-j+1}(t) \quad (82)$$

Wichtig ist, daß die benötigten $A_m$ und $B_m$ unabhängig von $i$ und $\alpha$ über $U_Q$ bzw. $U_{Q+1}$ berechnet werden können. Oben war formal $\tilde{A}_Q(W(s_0, V_{Q+1}))$ über das Hilfskonstrukt $U_Q^i(\alpha)$ bestimmt, welches in der resultierenden expliziten Darstellung aber nicht mehr benötigt wird.

**Zusammenfassung der Vorgehensweise:**

• Definiere

$$V_j := V, \qquad \text{für } j \in \{1, \dots, a\},$$

$$V_j := \{v_0\}, \qquad \text{für } j \in \{a + 1, \dots, Q + 1\},$$

$$V_j^i(\alpha) := \{v \in V; v_i = \alpha\}, \qquad \text{für } i = (j - 1) \cdot b + \hat{\imath},$$

$$\hat{\imath} \in \{1,...,b\},$$

$$j \in \{1, \dots a\}, \alpha \in \{\pm 1\}.$$

- Zu einer beliebigen aber festen Wahl von $y \in \mathbb{R}^N$ definiere für $q \in \{1,...,Q\}$

$$\mu_q : S \to \mathbb{R},$$

$$s \mapsto \exp\left(-\frac{1}{2\sigma^2}\sum_{j=1}^{n}\left(y_{n(q-1)+j} - C_j(s)\right)^2\right) = \exp\left(-\frac{1}{2\sigma^2}\Delta F_q(s)\right).$$

- Man berechne

$$A_m(s), \text{ für } s \in S, m \in \{1,...,a-1\},$$

$$B_m(s), \text{ für } s \in S, m \in \{1,...,Q\},$$

nach den oben angegeben Rekursionsformeln (57) und (70) und Startwerten $A_0(s)$, $B_0(s)$ mit (56) und (71).

- Man berechne alle $A_\alpha^i$, $i \in \{1,...,K\}$, $\alpha \in \{\pm 1\}$ über

$$A_\alpha^i(y) = \sum_{s \in S} A_{j-1}(s) \sum_{t \in T(s, V_j^{\hat{\imath}}(\alpha))} B_{Q-j+1}(t). \tag{83}$$

und bestimme die Soft-Outputs

$$L(U_i|y) = \ln\left(\frac{A_{+1}^i(y)}{A_{-1}^i(y)}\right), \quad i = 1, \dots, K.$$

Zusammen mit der Rekursionsformel aus dem vorangegangenen Abschnitt können alle $A_\alpha^i(y)$ jetzt gemeinsam mit $O(2^L \cdot Q)$ bzw. $O(K)$ Operationen statt $O(K2^K)$ Operationen berechnet werden.

Erinnerung: $L = k \cdot b$, $Q = a + k - 1$, $K = a \cdot b$, wobei $a$ die Anzahl der Nachrichtenbits ist.

Die numerische Komplexität zur Berechnung der Soft-Outputs ist also von exponentieller Ordnung auf lineare Ordnung vèrringert worden, wobei $a$, die Anzahl der Nachrichtenbits, die entscheidende Größe ist.

**Spezialfall: Binärer Zustandsübergang** ($b = 1$)

Im wichtigen Spezialfall b = 1 besteht die Menge $V$ der Zustandsübergangszeichen nur aus den beiden Elementen +1, -1. Die GSM-Codes gehören etwa zu diesem weit verbreiteten Spezialfall.

Da in der obigen Beschreibung jetzt $i = j$ und $V_j^{\hat{\imath}}(\alpha) = \{\alpha\}$, vereinfacht sich die Vorgehensweise wie folgt:

- Definiere

$$V_j := \{\pm 1\}, \text{ für } j \in \{1, \dots, a\},$$

$$V_j := \{+1\}, \text{ für } j \in \{a + 1, \ldots, Q + 1\}$$

- Zu einer beliebigen aber festen Wahl von $y \in \mathbb{R}^N$ definiere für $q \in \{1, \ldots, Q\}$

$$\mu_q : S \to \mathbb{R},$$

$$s \mapsto \exp\left(-\frac{1}{2\sigma^2}\sum_{j=1}^{n}\left(y_{n(q-1)+j} - C_j(s)\right)^2\right) = \exp\left(-\frac{1}{2\sigma^2}\Delta F_q(s)\right).$$

- Man berechne

$$A_m(s), \text{ für } s \in S, m \in \{1,\ldots,a-1\},$$

$$B_m(s), \text{ für } s \in S, m \in \{1,\ldots,Q\},$$

nach den Rekursionsformeln (57) und (70) und Startwerten $A_0(s)$, $B_0(s)$ mit (56) und (71).

- Man berechne alle $A_\alpha^i$, $i \in \{1,\ldots,K\}$, $\alpha \in \{\pm 1\}$ über

$$A_\alpha^i(y) = \sum_{s \in S} A_{i-1}(s) B_{Q-i+1}(T(s,\alpha)). \qquad (84)$$

und bestimme die Soft-Outputs

$$L(U_i|y) = \ln\left(\frac{A_{+1}^i(y)}{A_{-1}^i(y)}\right), \quad i = 1, \ldots, K.$$

**Algorithmische Umsetzung**

Man betrachte für die algorithmische Umsetzung das Trellis-Diagramm und die Abbildungen

$$\mathcal{T} = \{(s,q); \ s \in S, \ q = 0, \ldots, Q + 1\}$$

- Knotengewichte im Zustand $s$ des Trellis-Segments $q$

$$\mu : \ \mathcal{T} \to \mathbb{R},$$

$$(s, q) \mapsto \exp\left(-\frac{1}{2\sigma^2}\Delta F_q(s)\right)$$

- Teilsuinmen 'A' im Zustand s des Trellis-Segments $q$

$$A : \; \mathcal{T} \to \mathbb{R}.$$

$$(s, q) \mapsto A(s, q)$$

- Teilsummen 'B' im Zustand $s$ des Trellis-Segmeuts $Q - q + 1$

$$B : \; \mathcal{T} \to \mathbb{R},$$

$$(s,q) \mapsto B(s,q)$$

Die Abbildungen werden nur auf den sinnvollen Teilmengen des Definitionsbereiches ausgewertet.

**Fig.2** zeigt einen Algorithmus in Pseudocode-Notation, der ein Fortschreiten im Trellis-Diagramm unter Betrachtung aller Zustände zur Berechnung der Knotengewichte darstellt. Der Algorithmus veranschaulicht die obigen Ausführungen und ist aus sich heraus verständlich. Da der Wert von $\Delta F_q(s)$ nur mittelbar vom Zustand $s$ abhängt und direkt mit $C(s)$ gebildet wird, gilt

$$|\{\Delta F_q(s); \; s \in S\}| \le \min \{2^L, 2^n\},$$

d.h., für $n < L$ haben viele der obigen $\mu(s, q)$ den gleichen Wert. Abhängig vom speziellen Code läßt sich $\mu(s, q)$ in der Implementierung also mit weitaus weniger Operationen bestimmen.

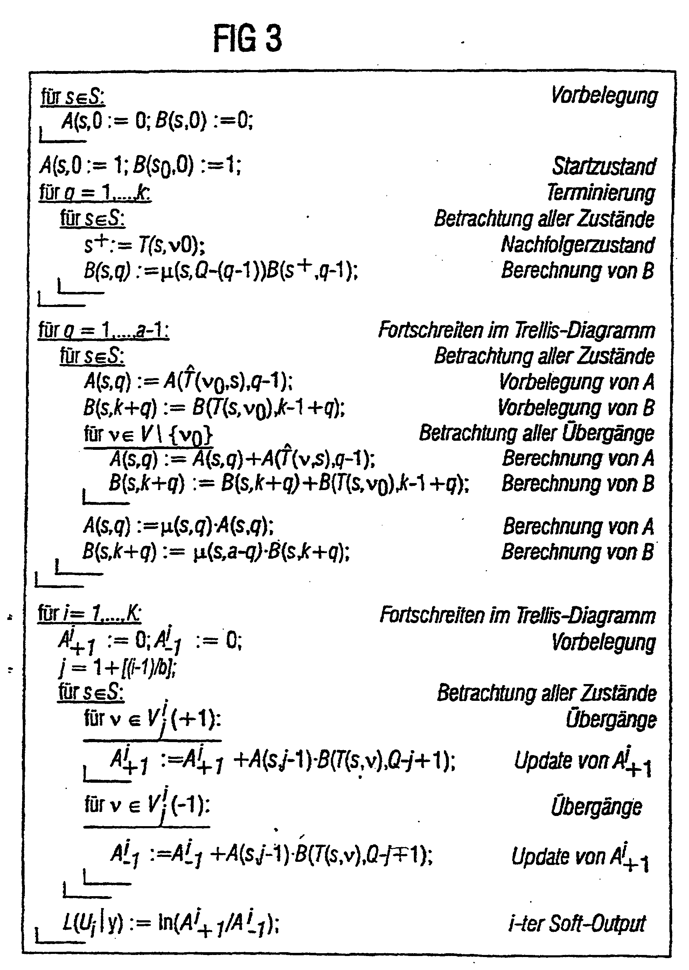

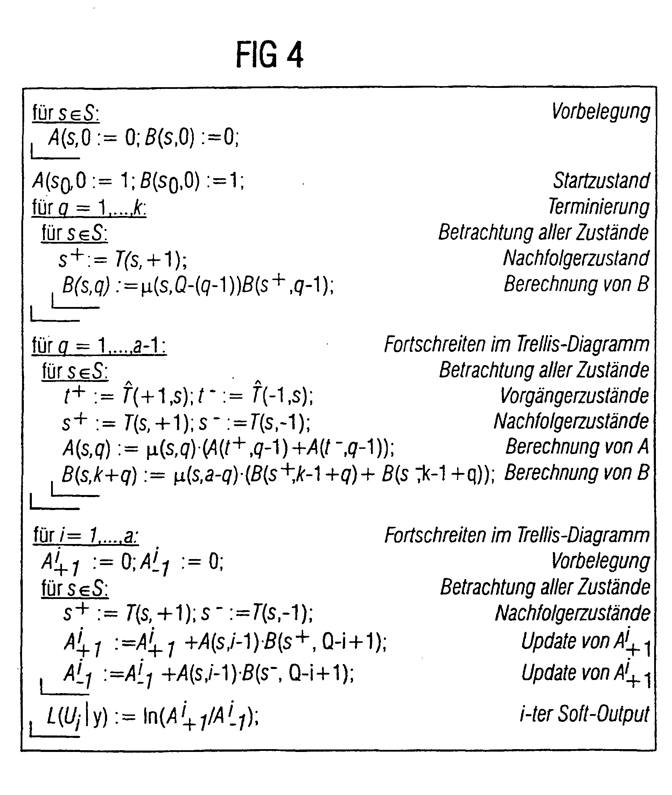

**Fig.3** und **Fig.4** zeigen je einen Algorithmus in Pseudocode-Notation zur Ermittlung von Softoutputs. Fig.3 bezieht sich auf den allgemeinen Fall und Fig.4 auf den Speziallfall für den binären Zustandsübergang ($b$ = 1). Beide Algorithmen veranschaulichen die obigen Ausführungen und sind aus sich heraus verständlich.

Bei geeigneter Implementierungsdarstellung von $V$ bzw. $V_i'(\alpha)$, etwa als Teilmengen von $\mathbb{N}$, lassen sich die obigen Iterationen $\upsilon \in V$ und $s \in S$ als gewöhnliche Programmschleifen implementieren. Vorkommende Indizes wie etwa $k - 1 + q$ werden bei der Implementierung natürlich nur einmal berechnet und nicht bei jedem Auftreten, wie es hier zur besseren Übersicht aufgeschrieben ist.

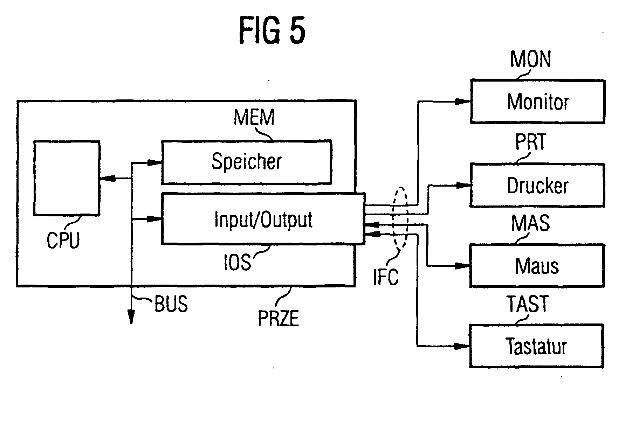

In **Fig.5** ist eine Prozessoreinheit PRZE dargestellt. Die Prozessoreinheit PRZE umfaßt einen Prozessor CPU, einen Speicher SPE und eine Input/Output-Schnittstelle IOS, die über ein Interface IFC auf unterschiedliche Art und Weise genutzt wird: Über eine Grafikschnittstelle wird eine Ausgabe auf einem Monitor MON sichtbar und/oder auf einem Drucker PRT ausgegeben. Eine Eingabe erfolgt über eine Maus MAS oder eine Tastatur TAST. Auch verfügt die Prozessoreinheit PRZE über einen Datenbus BUS, der die Verbindung von einem Speicher MEM, dem Prozessor CPU und der Input/Output-Schnittstelle IOS gewährleistet. Weiterhin sind an den Datenbus BUS zusätzliche Komponenten anschließbar, z.B. zusätzlicher Speicher, Datenspeicher (Festplatte) oder Scanner.

**Patentansprüche**

1. Verfahren zur Decodierung eines vorgegebenen Codeworts,

   (a) bei dem das Codewort mehrere Stellen mit unterschiedlichen Werten umfasst;

   (b) bei dem jede Stelle des Codeworts einem Soft-Output-Wert zugeordnet wird, wobei die Berechnungsvorschrift für den Soft-Output-Wert für jede Stelle des Codeworts bestimmt ist durch

$$L(U_i|y) = \ln\left(\frac{\sum\limits_{c\in\Gamma^i(+1)} \exp\left(-\frac{(y-c)^T(y-c)}{2\sigma^2}\right)}{\sum\limits_{c\in\Gamma^i(-1)} \pm\exp\left(-\frac{(y-c)^T(y-c)}{2\sigma^2}\right)}\right), \quad \text{für } i = 1\ldots,K,$$

wobei

| | |
|---|---|
| $L(U_i|y)$ | ein Sicherheitsmaß (Soft-Output) für die i-te Stelle des zu bestimmenden Codeworts; |
| y | ein zu decodierendes Demodulationsergebnis; |
| c | ein Codewort; |
| $\Gamma^i(\pm 1)$ | sämtliche Codewörter für $u_i = \pm 1$; |
| $\sigma^2$ | eine Varianz (Kanalstörung) |

bezeichnen;

(c) bei dem durch die Zuordnung der einzelnen Stellen des Codeworts zu Soft-Output-Werten die Decodierung desselben bestimmt wird, indem eine Eigenschaft eines Faltungscodes ausgenutzt wird, aus der hervorgeht, dass entsprechend einer Schieberegisteroperation Zustände bestimmt werden, aus denen eine Trellis-Darstellung hervorgeht, wobei bei den Schieberegisteroperationen taktweise Eingabeblöcke von Nachrichtenbits in das Schieberegister geschrieben werden;

(d) bei dem für eine beliebige Wahl von $y \in R^N$ Gewichte $\mu_q(s)$ für die Knoten (s, q) der Trellis-Darstellung berechnet werden durch Auswertung von

$$\mu_q : S \to \mathbf{R},$$
$$s \to \exp\left(-\frac{1}{2\sigma^2}\sum_{j=1}^{n}\left(y_{n(q-1)+j} - C_j(s)\right)^2\right)$$

mit

$$C_j(s) = \bigoplus_{i\in Mj} s^i$$

$1 \le j \le \boldsymbol{n}$, $\boldsymbol{n} \in$ N, wobei $M_1,\ldots M_n \subseteq \{1, \ldots, L\}$ charakterisierende Teilmengen sind, über die der Faltungscode definiert wird, wobei S = $\{\pm 1\}^L$ s $\in$ S, $s^i$ die i-te Komponente von s ist, wobei q $\in \{1,\ldots,Q\}$, Q = a + k - 1, a $\in$ **N**, k $\in$ **N**, k $\ge$ 2, L = k $\cdot$ b, b $\in$ **N**, wobei a die Anzahl der Eingabeblöcke ist, k die Blocklänge,des Schieberegisters ist, S die Menge der Schieberegisterzeichen ist, L die Bitlänge des Schieberegisters ist;

(e) bei dem Abbildungen $A_m$ anhand der Trellis-Darstellung bestimmt werden, wobei die Trellis-Darstellung in der natürlichen Richtung durchlaufen wird, wobei der Term $A_m$ bestimmt ist durch

$$A_m(s) = \mu_m(s)\sum_{t\in W(s,V_m)} A_{m-1}(t),$$

für m $\in$ N wobei V = $\{\pm 1\}^b$ die Menge an Zustandsübergangszeichen ist und $V_j \subseteq V, j \in N$ das Zustandsüber-gangszeichen nach j Shifts des Schieberegisters ist,

wobei

$$W(t,\hat{V}) = \left\{ s \in S; \exists \hat{v} \in \hat{V} \ni T(s,\hat{v}) = t \right\}$$

$$= \begin{cases} \left\{ \hat{T}(v,t); v \in V \right\}, & falls \ \tau(s) \in \hat{V} \\ 0 & sonst \end{cases}$$

wobei $\hat{V} \subseteq V$;

$$\tau : S \to V$$

wobei

$$s = (s^1;..., s^L)^T \to (s^{L-b+1},..., s^L)^T$$

wobei

$$\hat{T} : V \times S \to V$$

wobei

$$s = (v,s) \to (v^1,..., v^b, s^1,..., s^{L-b})^T$$

$$T : S \times V \to S,$$

wobei

$$(s,v) \to (s^{b+1},..., s^L, v^1,..., v^b)^T$$

und einem Startwert

$$A_0(s) = \begin{cases} 1: f\ddot{u}r \ s = s_0 \\ 0: \ sonst; \end{cases}$$

(f) bei dem Abbildungen $B_m$ anhand der Trellis-Darstellung bestimmt werden, wobei die Trellis-Darstellung entgegen der vorgegebenen Richtung durchlaufen wird, wobei der Term $B_m$ bestimmt ist durch

$$B_m(s) = \mu_{Q-m+1}(s) \sum_{t \in T(s, V_{Q-m+2})} B_{m-1}(t),$$

für $1 \leq m \leq Q$,
wobei zur Terminierung der Rekursion

$$B_0(s) = \left\{ \begin{array}{l} 1: \text{für } s = s_0 \\ 0: \text{sonst}; \end{array} \right.$$

bestimmt wird;

(g) bei dem Terme $A^i$ ermittelt werden, indem die Trellis-Darstellung erneut durchlaufen wird, wobei die bereits ermittelten Terme $A_m^\alpha$ und $B_m$ berücksichtigt werden gemäß der Beziehung

$$A_\alpha^i(y) = \sum_{s \in \varepsilon^*} A_{j-1}(s) \sum_{t \in T(s, V_j^i(\alpha))} B_{Q-j+1}(t)$$

wobei

$$j = \left[ \frac{i-1}{b} \right] + 1;$$

$$V_j^i(\alpha) = \left\{ v \in V; v_{\hat{i}} = \alpha \right\}, \quad \alpha \in \{\pm 1\};$$

wobei

$i \in \{1,...,K\}$, wobei $K = a \cdot b$, $j \in \{1,...,a\}$ und $\hat{i} \in \{1,...,n\}$ mit $i = (j-1) \cdot n + \hat{i}$

(h) bei dem die K Stellen des Codewortes bestimmt werden gemäß

$$L(U_i \mid y) = \ln\left( \frac{A_{+1}^i(y)}{A_{-1}^i(y)} \right),$$

$i = 1, ..., K$.

2. Verfahren nach einem der vorhergehenden Ansprüche,

   (a) bei dem der Faltungscode binäre Zustandsübergänge besitzt;
   (b) bei dem die Abbildungen $A_m$ rekursiv bestimmt sind durch

$$A_m(s) = \mu_m(s)\left(A_{m-1}\left(\hat{T}(+1,s)\right) + A_{m-1}\left(\hat{T}(-1,s)\right)\right), \quad \text{für } m \in N;$$

(c) bei dem die Abbildungen $B_m$ rekursiv bestimmt sind durch

$$B_m(s) = \mu_{Q-m-1}(s)\left(B_{m-1}\left(T(s,+1)\right) + B_{m-1}\left(T(s,-1)\right)\right),$$

für $1 \le m \le Q$;

(d) bei dem die Terme $A_\alpha^i$, $i \in \{1, ..., K\}$, $\alpha \in \{\pm 1\}$ ermittelt werden gemäß

$$A_\alpha^i(y) = \sum_{s \in S} A_{i-1}(s) B_{Q-1+1}\left(T(s,\alpha)\right).$$

3. Verfahren nach einem der vorhergehenden Ansprüche zum Einsatz in einem Mobilfunknetz.

4. Verfahren nach Anspruch 3, bei dem das Mobilfunknetz ein GSM-Netz ist.

5. Verfahren zur Decodierung eines verketteten Codes, wobei Soft-Output-Werte nach dem Verfahren einer der vorhergehenden Ansprüche ermittelt werden und die ermittelten Soft-Output-Werte als Eingangsdaten eines weiteren Decodierers verwendet werden.

6. Anordnung zur Decodierung eines vorgegebenen Codeworts, bei der eine Prozessoreinheit vorgesehen ist, die derart eingerichtet ist, dass damit ein Verfahren nach einem der vorhergehenden Ansprüche durchführbar ist.

**Claims**

1. Method for decoding a predetermined code word,

   (a) in which the code word comprises a number of positions having different values;

   (b) in which each position of the code word is allocated to a soft output value, the calculation rule for the soft output value for each position of the code word being determined by

$$L(U_i|y) = \ln\left(\frac{\sum_{c \in \Gamma^i(+1)} \exp\left(-\frac{(y-c)^T(y-c)}{2\sigma^2}\right)}{\sum_{c \in \Gamma^i(-1)} \pm \exp\left(-\frac{(y-c)^T(y-c)}{2\sigma^2}\right)}\right),$$

for i = 1...,K,
where

| | |
|---|---|
| $L(U_i\|y)$ | designates a soft output for the $i^{th}$ position of the code word to be determined; |
| y | designates a demodulation result to be decoded; |
| c | designates a code word; |
| $\Gamma^i(\pm 1)$ | designates all code words for $u_i = \pm 1$; |
| $\sigma^2$ | designates a variance (channel disturbance); |

(c) in which, by allocating the individual positions of the code word to soft output values, the decoding of the code word is determined by utilizing a characteristic of a convolutional code from which it follows that, according to a shift register operation, states are determined from which a trellis representation is produced, wherein input blocks of message bits are written clock pulse by clock pulse into the shift register during the shift register operations;

(d) in which, for an arbitrary choice of $y \in R^N$, weights $\mu_g(s)$ are calculated for the nodes (s, q) of the trellis representation by evaluating

$$\mu_q : S \to \mathbf{R},$$

$$s \to \exp\left(-\frac{1}{2\sigma^2} \sum_{j=1}^{n} \left(y_{n(q-1)+j} - C_j(s)\right)^2\right)$$

where

$$C_j(s) = \bigoplus_{i \in M_j} \circ \ s^i$$

$1 \leq j \leq n$, $n \in N$, where $M_1,...M_n \subseteq \{1, .., L\}$ **characterizing** subsets there which the convolutional code is defined, where $S = \{\pm 1\}^L$, $s \in S$, $s^i$ is the $i^{th}$ component of s, where $q \ \varepsilon \ \{1, ... , Q\}$, $Q = a + k - 1$, $a \ \varepsilon \ \mathbf{N}$, $k \ \varepsilon \ \mathbf{N}$, $k \geq 2$, $L = k \cdot b$, $b \ \varepsilon \ \mathbf{N}$, where a is the number of input blocks, k is the block length of the shift register, S is the set of shift register characters, L is the bit length of the shift register;

(e) in which mappings $A_m$ are determined by means of the trellis representation, passing through the trellis representation in the natural direction, wherein the term $A_m$ is determined by

$$A_m(s) = \mu_m(s) \sum_{t \in W(s, V_m)} A_{m-1}(t),$$

for $m \in N$
where $V = \{\pm 1\}^b$ is the set of state transition symbols and $V_j \subseteq V$, $j \ \varepsilon \ N$ is the state transition symbol after j shifts of the shift register,
where

$$W(t, \hat{V}) = \left\{s \in S; \exists \hat{v} \in \hat{V} \ \ni \ T(s, \hat{v}) = t\right\}$$

$$= \begin{cases} \left\{\hat{T}(v,t); v \in V\right\}, & if \ \tau(s) \in \hat{V} \\ 0 & else \end{cases}$$

where $\hat{V} \subseteq V$;

$$\tau : S \to V$$

where $s = (s^1, ..., s^L)^T \rightarrow (s^{L-b+1}, ..., S^L)^T$;

$$\overset{\wedge}{T} : V \times S \rightarrow V$$

where $s = (v,s) \rightarrow (v^1,...,v^b,s^1,...,s^{L-b})^T$;

$$T : S \times V \rightarrow S,$$

where $(s, v) \rightarrow (s^{b+1},...,s^L,v^1,...,v^b)^T$; and a starting value

$$A_0(s) = \begin{cases} 1: \text{ for } s = s_0 \\ 0: \text{ else }; \end{cases}$$

(f) in which mappings $B_m$ are determined by means of the trellis representation, passing through the trellis representation against the predetermined direction, the term $B_m$ being determined by

$$B_m(s) = \mu_{Q-m+1}(s) \sum_{t \in T(s, V_{Q-m+2})} B_{m-1}(t),$$

for $1 \leq m \leq Q$,
where

$$B_0(s) = \begin{cases} 1: \text{ for } s = s_0 \\ 0: \text{ else }; \end{cases}$$

is determined for terminating the recursion;

(g) in which terms $A^i$ are determined by again passing through the trellis representation, the terms $A_m$ and $B_m$ already determined being taken into consideration in accordance with the relation

$$A_\alpha^i(y) = \sum_{s \in \varepsilon'} A_{j-1}(s) \sum_{t \in T(s, V_j^i(\alpha))} B_{Q-j+1}(t)$$

where

$$j = \left\lceil \frac{i-1}{b} \right\rceil + 1;$$

$$V_j^i(\alpha) = \left\{ v \in V; v_{\hat{i}} = \alpha \right\}, \ \alpha \in \{\pm 1\};$$

where
i$\varepsilon$ {1, ...,K}, where K = a·b, j$\varepsilon$ {1, ...,a} and î$\varepsilon$ {1, ...n} with i=(j-1)·n+î

(h) in which the K positions of the code word are determined in accordance with

$$L(U_l \mid y) = \ln\left( \frac{A_{+1}^i(y)}{A_{-1}^i(y)} \right),$$

l = 1, ..., K.

**2.** Method according to one of the preceding claims,

   (a) in which the convolutional code has binary state transitions;
   (b) in which the mappings $A_m$ are recursively determined by

$$A_m(s) = \mu_m(s)\left( A_{m-1}\left(\hat{T}(+1,s)\right) + A_{m-1}\left(\hat{T}(-1,s)\right) \right),$$

for $m \in N$ ;
   (c) in which the mappings $B_m$ are recursively determined by

$$B_m(s) = \mu_{Q-m-1}(s)\left( B_{m-1}\left(T(s,+1)\right) + B_{m-1}\left(T(s,-1)\right) \right),$$

for $1 \le m \le Q$;
   (d) in which the terms $A_\alpha^i$, i $\varepsilon$ {1, ..., K}, $\alpha$ $\varepsilon$ {$\pm$ 1} are determined in accordance with

$$A_\alpha^i(y) = \sum_{s \in S} A_{i-1}(s) B_{Q-i+1}\left(T(s,\alpha)\right).$$

**3.** Method according to one of the preceding claims for use in a mobile radio network.

**4.** Method according to Claim 3, in which the mobile radio network is a GSM network.

**5.** Method for decoding a concatenated code, in which soft output values are determined in accordance with the method of one of the preceding claims and the soft output values determined are used as input data of a further decoder.

**6.** Arrangement for decoding a predetermined code word in which a processor unit is provided which is set up in such a manner so that it can be used for performing a method according to one of the preceding claims.

**Revendications**

1. Procédé destiné au décodage d'un mot code donné,

(a) dans lequel le mot code comporte plusieurs positions ayant des valeurs différentes;
(b) dans lequel chaque position du mot code est affectée à une valeur de sortie souple (ou soft-output), la règle de calcul pour la valeur de sortie souple (ou soft-output) étant déterminée pour chaque position du mot code par

$$L(U_i|y) = \ln\left(\frac{\sum\limits_{c\in\Gamma^i(+1)} \exp\left(-\frac{(y-c)^T(y-c)}{2\sigma^2}\right)}{\sum\limits_{c\in\Gamma^i(-1)} \pm\exp\left(-\frac{(y-c)^T(y-c)}{2\sigma^2}\right)}\right), \text{ pour } i = 1...,K,$$

dans laquelle

$L(U_i|y)$     est une dimension de sécurité (sortie souple ou soft-output) pour la i-ème position du mot code à déterminer;
y     est un résultat de démodulation à décoder;
c     est un mot code;
$\Gamma^i(\pm 1)$     représente tous les mots code pour $u_i = \pm 1$ ;
$\sigma^2$     désigne une variance (perturbation du canal);

(c) dans lequel, grâce à la concordance entre les différentes positions du mot code avec les valeurs de sortie souple (ou soft-output), le décodage de celles-ci est défini en utilisant une propriété d'un code de convolution duquel il ressort que, conformément à une opération d'un registre à décalage, on détermine des états, desquels il découle une représentation de Trellis, des blocs d'entrée de bits d'information étant écrits au rythme de l'horloge dans le registre à décalage au cours des opérations du registre à décalage;
(d) dans lequel, pour un choix quelconque de $y \in R^N$, des pondérations $\mu_q(s)$ sont calculées pour les noeuds (s, q) de la représentation de Trellis par évaluation de

$$\mu_q : S \to R,$$

$$s \to \exp\left(-\frac{1}{2\sigma^2}\sum_{j=1}^{n}\left(y_{n(q-1)+j} - C_j(s)\right)^2\right)$$

avec

$$C_j(s) = \bigoplus_{i\in Mj} s^i$$

$1 \leq j \leq n, n \in N$ , dans laquelle $M_1,...M_n \subseteq \{1, .., L\}$ sont des sous-ensembles caractérisants par l'intermédiaire desquels le code de convolution est défini, dans laquelle $S = \{\pm 1\}^L$ , $s \in S$, et $s^i$ est la i-ème composante de s, dans laquelle $q \in \{1,...,Q\}$, $Q = a + k - 1$, $a \in N$, $k \in N$, $k \geq 2$, $L = k \cdot b$, $b \in N$, dans laquelle a est le nombre de blocs d'entrée, k, la longueur de bloc du registre à décalage, S, l'ensemble des signes du registre à décalage, L, la longueur de bit du registre à décalage;
(e) dans lequel des images $A_m$ sont déterminées à l'aide de la représentation de Trellis, la représentation de Trellis étant parcourue dans le sens naturel, le terme $A_m$ étant déterminé par

$$A_m(s) = \mu_m(s) \sum_{t \in W(s,V_m)} A_{m-1}(t),$$

pour m ∈ N
dans laquelle V = {± 1}$^b$ est l'ensemble des signes de transition entre états et $V_j \subseteq V$, j ∈ N est le signe de transition entre états après j décalages du registre à décalage,
avec

$$W(t,\hat{V}) = \left\{ s \in S; \exists \hat{v} \in \hat{V} \ni T(s,\hat{v}) = t \right\}$$

$$= \begin{cases} \left\{ \hat{T}(v,t); v \in V \right\} & si \quad \tau(s) \in \hat{V} \\ 0 & dans\ les\ autres\ cas, \end{cases}$$

avec $\hat{V} \subseteq V$ ;

$$\tau : S \to V$$

avec

$$S = (S^1,...,s^L)^T \to (S^{L-b+1},...,s^L)^{T;}$$

avec

$$\hat{T} : V \times S \to V$$

$$s = (v,s) \to (v^1,...,v^b,s^1,...,s^{L-b)T} ;$$

$$T : S \times V \to S,$$

avec

$$(s,v) \to (s^{b+1},...,s^L,v^1,...,v^b)^T ;$$

et une valeur de démarrage

$$A_0(s) = \begin{cases} 1: pour\ s=s_0 \\ 0: dans\ les\ autres\ cas; \end{cases}$$

(f) dans lequel des images $B_m$ sont définies à l'aide de la représentation de Trellis, la représentation de Trellis étant parcourue dans le sens contraire au sens donné, le terme $B_m$ étant déterminé par

$$B_m(s) = \mu_{Q-m+1}(s) \sum_{t \in T(s, V_{Q-m+2})} B_{m-1}(t),$$

pour $1 \leq m \leq Q$, alors qu'est défini

$$B_0(s) = \left\{ \begin{array}{ll} 1: & pour\ s=s_0 \\ 0: & dans\ les\ autres\ cas; \end{array} \right.$$

pour la définition du terme de la récurrence;

(g) dans lequel sont déterminés, conformément à la relation suivante, des termes $A^i$ en parcourant de nouveau la représentation de Trellis, tout en tenant compte des termes $A_m$ et $B_m$ qui ont déjà été déterminés,

$$A_\alpha^i(y) = \sum_{s \in s} A_{j-1}(s) \sum_{t \in T(s, V_j^i(\alpha))} B_{Q-j+1}(t)$$

avec

$$j = \left[ \frac{i-1}{b} \right] + 1;$$

$$V_j^i(\alpha) = \left\{ v \in V; v_{\hat{i}} = \alpha \right\}, \quad \alpha \in \{\pm 1\};$$

avec $i \in \{1,...,K\}$, avec $K = a \cdot b$, $j \in \{1,....,a\}$ et $\hat{i} \in \{1,...,n\}$ avec $\hat{i} = (j-1) \cdot n + \hat{i}$

(h) dans lequel les K positions du mot code sont déterminées conformément à

$$L(U_i \mid y) = \ln\left( \frac{A_{+1}^i(y)}{A_{-1}^i(y)} \right),$$

$i=1,...,K.$

2.  Procédé selon l'une des revendications précédentes

    (a) dans lequel le code de convolution a des transitions binaires entre états;

    (b) dans lequel les images $A_m$ sont déterminées d'une façon récurrente par

$$A_m(s) = \mu_m(s)\Big(A_{m-1}\big(\hat{T}(+1,s)\big) + A_{m-1}\big(\hat{T}(-1,s)\big)\Big),\ \text{pour m} \in \mathrm{N};$$

(c) dans lequel les images $B_m$ sont déterminées d'une façon récurrente par

$$B_m(s) = \mu_{Q-m-1}(s)\Big(B_{m-1}\big(T(s,+1)\big) + B_{m-1}\big(T(s,-1)\big)\Big),$$

pour $1 \le m \le Q$;

(d) dans lequel les termes $A_\alpha^i$, $i \in \{1, \dots, K\}$, $\alpha \in \{\pm 1\}$ sont déterminés conformément à

$$\Lambda_\alpha^i(y) = \sum_{s \in S} A_{i-1}(s) B_{Q-1+1}\big(T(s,\alpha)\big).$$

**3.** Procédé selon l'une des revendications précédentes destiné à être mis en oeuvre dans un réseau de radio mobile.

**4.** Procédé selon la revendication 3, dans lequel le réseau de radio mobile est un réseau GSM.

**5.** Procédé destiné au décodage d'un code à enchaînement, les valeurs de sorties souples (ou soft-outputs) étant déterminées suivant le procédé de l'une des revendications précédentes et les valeurs de sorties souples (ou soft-outputs) étant utilisées comme données d'entrée d'un autre décodeur.

**6.** Dispositif destiné au décodage d'un mot code donné, dans lequel il est prévu une unité à processeur conçue de telle manière qu'elle permette d'exécuter un procédé selon l'une des revendications précédentes.

# FIG 1

$u \in \{\pm 1\}^K$     $c \in \{\pm 1\}^N$

Quelle → Quellen-codierer → Krypto-codierer → Kanal-codierer → Modulator

201    202    203    204    205

$s : R \rightarrow R$

Störung → Physikal. Kanal

206

$\tilde{s} : R \rightarrow R$

$L(U_\bullet | y) \in R^K$     $y \in R^N$

Senke ← Quellen-decod. ← Krypto-decod. ← Kanal-decod. ← Demodul.

211    210    209    208    207

# FIG 2

für $q = 1, \ldots, Q$:

    für $s \in S$:

$$\mu(s,q) := \exp\left(\frac{-1}{2\sigma^2} \Delta F_q(s)\right);$$

## FIG 3

**für $s \in S$:**        *Vorbelegung*
  $A(s,0) := 0;\ B(s,0) := 0;$

$A(s,0) := 1;\ B(s_0,0) := 1;$       *Startzustand*
**für $q = 1,\dots,k$:**       *Terminierung*
  **für $s \in S$:**       *Betrachtung aller Zustände*
    $s^+ := T(s,v0);$       *Nachfolgerzustand*
    $B(s,q) := \mu(s,Q-(q-1))B(s^+,q-1);$       *Berechnung von B*

**für $q = 1,\dots,a-1$:**       *Fortschreiten im Trellis-Diagramm*
  **für $s \in S$:**       *Betrachtung aller Zustände*
    $A(s,q) := A(\hat{T}(v_0,s),q-1);$       *Vorbelegung von A*
    $B(s,k+q) := B(T(s,v_0),k-1+q);$       *Vorbelegung von B*
    **für $v \in V \setminus \{v_0\}$**       *Betrachtung aller Übergänge*
      $A(s,q) := A(s,q) + A(\hat{T}(v,s),q-1);$       *Berechnung von A*
      $B(s,k+q) := B(s,k+q) + B(T(s,v_0),k-1+q);$       *Berechnung von B*

    $A(s,q) := \mu(s,q) \cdot A(s,q);$       *Berechnung von A*
    $B(s,k+q) := \mu(s,a-q) \cdot B(s,k+q);$       *Berechnung von B*

**für $i = 1,\dots,K$:**       *Fortschreiten im Trellis-Diagramm*
  $A^i_{+1} := 0;\ A^i_{-1} := 0;$       *Vorbelegung*
  $j = 1 + [(i-1)/b];$
  **für $s \in S$:**       *Betrachtung aller Zustände*
    **für $v \in V^i_j(+1)$:**       *Übergänge*
      $A^i_{+1} := A^i_{+1} + A(s,j-1) \cdot B(T(s,v),Q-j+1);$       *Update von $A^i_{+1}$*

    **für $v \in V^i_j(-1)$:**       *Übergänge*

      $A^i_{-1} := A^i_{-1} + A(s,j-1) \cdot B(T(s,v),Q-j\mp1);$       *Update von $A^i_{+1}$*

  $L(U_i | y) := \ln(A^i_{+1} / A^i_{-1});$       *i-ter Soft-Output*

# FIG 4

<u>für $s \in S$:</u>                                                                    *Vorbelegung*

  $A(s,0) := 0; B(s,0) := 0;$

$A(s_0,0) := 1; B(s_0,0) := 1;$                                        *Startzustand*

<u>für $q = 1,...,k$:</u>                                                      *Terminierung*

  <u>für $s \in S$:</u>                                          *Betrachtung aller Zustände*

    $s^+ := T(s,+1);$                                  *Nachfolgerzustand*

    $B(s,q) := \mu(s,Q-(q-1))B(s^+,q-1);$            *Berechnung von B*

<u>für $q = 1,...,a-1$:</u>                                    *Fortschreiten im Trellis-Diagramm*

  <u>für $s \in S$:</u>                                          *Betrachtung aller Zustände*

    $t^+ := \hat{T}(+1,s); t^- := \hat{T}(-1,s);$      *Vorgängerzustände*

    $s^+ := T(s,+1); s^- := T(s,-1);$              *Nachfolgerzustände*

    $A(s,q) := \mu(s,q) \cdot (A(t^+,q-1) + A(t^-,q-1));$   *Berechnung von A*

    $B(s,k+q) := \mu(s,a-q) \cdot (B(s^+,k-1+q) + B(s^-,k-1+q));$   *Berechnung von B*

<u>für $i = 1,...,a$:</u>                                      *Fortschreiten im Trellis-Diagramm*

$A^i_{+1} := 0; A^i_{-1} := 0;$                                          *Vorbelegung*

<u>für $s \in S$:</u>                                          *Betrachtung aller Zustände*

  $s^+ := T(s,+1); s^- := T(s,-1);$              *Nachfolgerzustände*

  $A^i_{+1} := A^i_{+1} + A(s,i-1) \cdot B(s^+, Q-i+1);$   *Update von $A^i_{+1}$*

  $A^i_{-1} := A^i_{-1} + A(s,i-1) \cdot B(s^-, Q-i+1);$   *Update von $A^i_{+1}$*

$L(U_i|y) := \ln(A^i_{+1}/A^i_{-1});$                                   *i-ter Soft-Output*

# FIG 5

MON

Monitor

PRT

Drucker

MAS

Maus

TAST

Tastatur

MEM

Speicher

Input/Output

CPU

IOS

BUS

PRZE

IFC